# EUROPEAN PATENT APPLICATION

(11) **EP 4 801 221 A1**
(43) Date of publication of application: **02.09.2026**
(21) Application number: 25160470.8
(22) Date of filing: 27.02.2025
(51) Int. Cl.: H10D 12/00, H10D 62/13

(54) **BI-MODE INSULATED GATE TRANSISTOR AND OPERATING METHOD**

(71) Applicant: Hitachi Energy Ltd, 8050 Zürich (CH)
(72) Inventor: Race, Salvatore, 5400 Baden (CH); Boksteen, Boni Kofi, 5600 Lenzburg (CH); De Michielis, Luca, 5000 Aarau (CH)
(74) Representative: Epping - Hermann - Fischer

(57) **Abstract**

In one embodiment, the bi-mode insulated gate transistor (1), BiGT, comprises:
- a pilot region (21) and a mixed region (22) at a bottom side (20),
- a first region (31) at a top side (30) opposite the bottom side (20) and atop the pilot region (21), and a second region (32) at the top side (30) and atop the mixed region (22), wherein
- the first region (31) and the second region (32) are each provided with a gate electrode (41, 42), and
- the gate electrodes (41) in the first region (31) and in the second region (32) are electrically addressable independent from one another.

## Description

A bi-mode insulated gate transistor, BiGT, is provided. Further, an operating method for such a BiGT is also provided.

Documents US 2010/0276727 Al, WO 2015/097157 A1 and WO 2023/117261 A1 refer to reverse-conducting insulated gate bipolar transistors, RC-IGBTs.

Document US 2023/0343863 A1 refers to a semiconductor device having a first gate electrode and a second gate electrode.

A problem to be solved is to provide a BiGT that has improved electrical properties.

This object is achieved, inter alia, by a BiGT and by an operating method as defined in the independent claims. Exemplary further developments constitute the subject-matter of the dependent claims.

For example, a semiconductor device, like a BiGT, comprises a pilot region and a mixed region at a bottom side. The pilot region is homogeneously of a second conductivity type and the mixed region comprises sub-region of the second conductivity type and of a first conductivity type, said sub-regions are arranged in an alternating manner. At a top side opposite the bottom side, a semiconductor body of the semiconductor device is provided with two gate electrodes that are assigned to the pilot region and the mixed region, respectively. Said electrodes are separate from each other and, thus, can individually be addressed.

Thus, especially a Two-gates BiGT is provided.

Herein, the benefits of integrating two control terminals, that is, gates, to a BiGT, namely a reverse conducting insulated gate bipolar transistor or RC-IGBT for short, is described. By integrating multiple gates, it is possible to improve the dynamic behavior of power semiconductor devices and to exploit the potential of the back-side pattern of the BiGT.

High-voltage semiconductor device, for example, based on silicon, can be provided with multiple gates. By doing so, namely de-saturation control, like plasma reduction before turn-off, can be achieved for improving V_{cesat}-E_{off} trade-off; V_{cesat} stands for the saturation voltage between a collector electrode and an emitter electrode, and E_{off} stands for the energy loss during turn-off of the semiconductor device. Especially, the adoption of multiple gates exploiting the potential of the back-side pattern can significantly reduce the turn-off losses E_{off} making the BiGt having two gates described herein competitive also at lower voltage classes. The devices described herein may thus also be referred to as bi-mode insulated two-gate transistor or Bi2GT for short.

A BiGT may be seen as a snap-back free reverse-conducting, RC, IGBT. The snap-back free behavior is achieved thanks to a back-side pattern with dedicated reverse conducting P-N regions for the RC case in the mixed region and also having a P-region as the pilot region, for example.

In at least one embodiment, the semiconductor device comprises:
- a pilot region and a mixed region at a bottom side,
- a first region at a top side opposite the bottom side and atop the pilot region, and a second region at the top side and atop the mixed region,
wherein
- the first region and the second region are each provided with a gate electrode, and
- the gate electrodes in the first region and in the second region are electrically addressable independent from one another.

For example, the semiconductor device is a BiGT.

According to at least one embodiment, seen in top view of the top side, the first region at the top side above the pilot region is as wide as or is wider than the pilot region at the bottom side. Especially, the first region may be at most twice as broad as the pilot region. This may apply especially perpendicular to at least one direction of main extent of the pilot region if the latter is not of circular shape. For example, if the pilot region is of cross-shape, this may apply for every cross-section perpendicular to the bars forming said cross.

If the first region protrudes from the pilot region, seen in cross-section, then this protrusion may be symmetric or may also be asymmetric.

For example, for a width W1 of the first region and a width Wp of the pilot region the following applies, in at least one or in most or in all of cross-sectional views through the pilot region, especially perpendicular to the at least one direction of main extent:
W1 = Wp or Wp < W1 ≤ 3 Wp or 1.05 Wp ≤ W1 ≤ 2 Wp or
1.1 Wp ≤ W1 ≤ 1.5 Wp.

If the first region is too wide, in this case the conduction losses during a delay time might be relatively high, thus limiting performance and reliability.

According to at least one embodiment, seen in top view of the top side, the first region is congruent with the pilot region. Alternatively or additionally, the second region is congruent with the mixed region. This may apply, for example, with a tolerance of at most 1 mm or of at most 0.5 mm or of at most 0.2 mm or of at most 40 µm in lateral directions in parallel with the top side. Alternatively or additionally, said tolerance is at most 20% or is at most 10% or is at most 2%of a lateral extent of the top side.

For example, in case of a polygonal top face having an even number of corners, the lateral extent is the length of a longest diagonal of the top side, in case of a polygonal top face having an odd number of corners, the lateral extent is the largest height of said polygon, and in case of a round, like circular, top side the lateral extent is a largest diameter of the top side. The same may apply for a bottom side of the semiconductor device opposite the top side.

According to at least one embodiment, seen in top view of the top side, the second region mostly or completely surrounds the first region. That is, all around the first region the second region is present. This may analogously apply for the pilot region and the mixed region. In this case, 'mostly' may mean that, seen from a center of figure of the first region or of the pilot region, the second region or the mixed region is around the first region or the pilot region, respectively, for an angular range of at least 240° or of at least 300° or of at least 330°; in case of 'all around', this value is 360°.

According to at least one embodiment, the semiconductor device further comprises a first contact pad and a second contact pad for the gate or control terminal. Said contact pads are located, for example, at the top side.

According to at least one embodiment, the gate electrode in the first region is in electrical contact with the first contact pad and the gate electrode in the second region is in electrical contact with the second contact pad. That is, the gate electrodes can electrically be connected by using the first and second contact pads. For example, said contact pads are configured for being connected by bond wires.

It is possible that there is just one first contact pad and just one second contact pad. However, it is also possible that there is a plurality of the first contact pads and/or of the second contact pads.

According to at least one embodiment, the first contact pad is distant from and electrically separated from the second contact pad. In case of a plurality of the first contact pads and/or of the second contact pads this may apply pair wisely for all the contact pads. 'Distant' may mean that the distance between the respective contact pads is at least 10% or is at least 30% or is at least 60% of the lateral extent of the top side.

Otherwise, the contacts pads can be next to each other, that is, a distance between the contact pads may be at most 10% or at most 5% or at most 2% of the lateral extent.

According to at least one embodiment, seen in top view of the top side, at least one of the first contact pad or the second contact pad is placed at a corner of the top side. For example, the contact pads are in opposite corners of the top side.

According to at least one embodiment, the semiconductor device further comprises a semiconductor body. For example, the semiconductor body is made of a semiconductor substrate and/or a semiconductor layer sequence that may be epitaxially grown. The semiconductor body comprises a plurality of differently doped regions. Especially, the pilot region and the mixed region are part of the semiconductor body.

According to at least one embodiment, the semiconductor device further comprises a collector electrode and an emitter electrode. Said electrodes may be metallic electrodes. For example, the emitter electrode is located at the top side so that the top side is an emitter side of the semiconductor body. Correspondingly, the collector electrode may be located at the bottom side so that the bottom side is a collector side of the semiconductor body.

For example, the collector electrode is in direct contact with the semiconductor body at all of the bottom side or at most of the bottom side. 'Most' may mean a proportion of at least 60% or of at least 80% or of at least 95% or of at least 99%. Alternatively or additionally, the top side of the semiconductor body is mostly not in direct contact with the emitter electrode. For example, at most of the top side the gate electrodes extend between the top side and the emitter electrode. Thus, the emitter electrode may be in direct contact with the top side only in places, like in a stripe pattern or in a dot pattern.

According to at least one embodiment, the semiconductor body comprises one or a plurality of emitter regions. The at least one emitter region is of the first conductivity type. For example, the first conductivity type is N-conductive. Thus, the at least one emitter region may be N-doped.

According to at least one embodiment, the semiconductor body comprises one or a plurality of well regions. The at least one well region is of the second conductivity type that is different from the first conductivity type. For example, the second conductivity type is P-conductive. Thus, the at least one well region may be P-doped.

According to at least one embodiment, each of the emitter regions is embedded in one of the well regions. There may be a one-to-one correspondence between the well regions and the emitter regions.

According to at least one embodiment, the at least one emitter region is electrically contacted by the emitter electrode. Thus, the emitter electrode is in direct electrical contact with the at least one emitter region.

According to at least one embodiment, the semiconductor body further comprises one or a plurality of drift regions. The at least one drift region is of the first conductivity type. The at least one drift region may be weaker doped than the at least one emitter region.

According to at least one embodiment, the at least one well region is embedded in the drift region. The at least one well region may start at the top side. It is possible that the at least one well region does not completely run through the drift region towards the bottom side. That is, the at least one well region may terminate distant from the pilot and mixed regions.

According to at least one embodiment, seen in cross-section, the gate electrodes run from next to the emitter regions along the associated well regions to the drift region. Thus, the gate electrodes may span across the well regions. Hence, next to the top side the gate electrodes may influence an electric current through the well regions from the respective emitter regions and directed to the bottom side.

According to at least one embodiment, the gate electrodes are electrically insulated from the emitter electrode and the semiconductor body by means of one or a plurality of electrical insulation layers. Thus, in the intended use there is no flow of current from the gate electrodes into the semiconductor body.

According to at least one embodiment, the pilot region is uniformly of the second conductivity type. For example, the pilot region has a constant thickness.

According to at least one embodiment, the mixed region comprises one or a plurality of first sub-regions of the first conductivity type and one or a plurality of second sub-regions of the second conductivity type. The first and second sub-regions can be arranged in an alternating manner. It is possible that the first and second sub-regions are optionally all of a same width, seen in cross-section, and/or of a same size, seen in top view.

The second sub-regions may be produced from regions of the first conductivity type by a doping over with a dopant for the second conductivity type. Thus, the second sub-regions may be both P-doped and N-doped but with a resulting effective conductivity of the second conductivity type. Optionally, the mixed region is of a constant thickness that may be the same as the thickness of the pilot region.

According to at least one embodiment, the pilot region and the mixed region directly adjoin the collector electrode. Thus, current may flow directly from the mixed and pilot regions into the collector electrode.

According to at least one embodiment, the pilot region and/or the mixed region run in parallel with the collector electrode.

According to at least one embodiment, the semiconductor body is of silicon. However, the semiconductor body may alternatively be of a wide-bandgap semiconductor material like SiC, Ga₂O₃ or GaN as well.

According to at least one embodiment, seen in top view of the bottom side, the pilot region has the shape of a plus sign, that is, of a Hellenic cross. Other shapes of the pilot region are in principle also possible, like star-shapes or cross crosslet-shapes or two-barred cross-shapes, like Jagiellonian cross-shapes.

According to at least one embodiment, the gate electrodes are of a planar design. Hence, the gate electrodes are located on top of the top side. Possibly, the gate electrodes run in parallel with the top side. Especially, the gate electrodes may not run into the semiconductor body and, thus, may not penetrate the top side.

For the emitter electrode it is possible to run into the semiconductor body just to electrically contact the at least one emitter region and optionally also the at least one well region.

According to at least one embodiment, the gate electrodes are of a trench design. Thus, the gate electrodes are arranged in one or a plurality of trenches. The at least one trench and, thus, the gate electrodes may extend from the top side into the semiconductor body towards the bottom side but preferably not until the bottom side. Hence, the gate electrodes are partially or completely arranged in trenches extending from the emitter side into the semiconductor body, for example, seen in cross-section perpendicular to the top side. The trenches may terminate within the drift region distant from the pilot region and the mixed region and, thus, distant from the bottom side.

According to at least one embodiment, seen in top view of the top side, in the mixed region there is no fixed correlation between the emitter regions and the first sub-regions and/or the second sub-regions.

According to at least one embodiment, the semiconductor device is configured for a voltage between the emitter electrode and the collector electrode of at least 0.6 kV or of at least 1.2 kV or of at least 3 kV. Alternatively or additionally, said voltage is at most 10 kV or is at most 7 kV. Hence, for example, the respective layer thicknesses of gate insulations, drift regions, well regions and so on are configured to withstand said voltage.

Alternatively or additionally, the semiconductor device is configured for a current between the emitter electrode and the collector electrode of at least 0.01 kA or of at least 0.1 kA of at least 1 kA and/or of at most 100 kA or of at most 10 kA.

A method for operating the semiconductor device is additionally provided. By means of the method, a semiconductor device as indicated in connection with at least one of the above-stated embodiments is operated. Features of the semiconductor device are therefore also disclosed for the method and vice versa.

In at least one embodiment, the method is for operating the semiconductor device, like a BiGT, and comprises:
- repeatedly turning on and turning off the semiconductor device by applying different voltages to the gate electrodes, wherein the gate electrodes are addressed independently of one another.

According to at least one embodiment, per each operation cycle of the semiconductor device, the gate electrode in the first region is turned off prior to the gate electrode in the second region. Hence, the gate electrodes in the first region may be addressed to turn off the semiconductor device earlier that the gate electrode in the second region. Thus, there is an intentional time offset between addressing the gate electrodes.

For example, said time offset is at least 5 µs and/or is at most 100 µs or is at most 1000 µs. Alternatively or additionally, said time offset is at least 0.1% and/or is at most 25% of a duration of the operation cycle.

According to at least one embodiment, per each operation cycle of the semiconductor device, the gate electrode in the first region and the gate electrode in the second region are turned on simultaneously. Hence, both gate electrodes may be addressed to turn on the semiconductor device at a same time with no intentional time offset. Otherwise, there may be an intentional time offset; if so, the gate electrode in the first region may be turned on before the gate electrode in the second region.

A semiconductor device described herein and an operating method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic cross-sectional view of an exemplary embodiment of a semiconductor device described herein,
- Figure 2: is a schematic bottom view of the semiconductor device of Figure 1,
- Figure 3: is a schematic top view of the semiconductor device of Figure 1,
- Figure 4: is a schematic top view of a modification of a semiconductor device for illustrating the invention,
- Figure 5: is a schematic illustration of an exemplary embodiment of an operating method for semiconductor devices described herein,
- Figures 6 to 8: are schematic top views of exemplary embodiments of semiconductor devices described herein,
- Figure 9: is a schematic cross-sectional view of an exemplary embodiment of a semiconductor device described herein, and
- Figure 10: shows schematic top views of exemplary embodiments of semiconductor devices described herein.

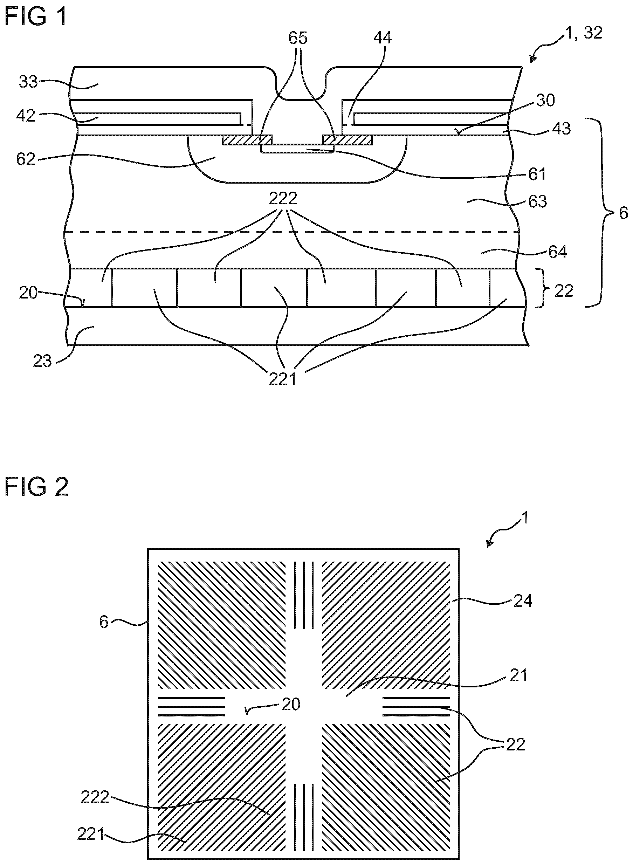

Figures 1 to 3 illustrate an example of a semiconductor device 1. For example, the semiconductor device 1 is a bi-mode insulated gate transistor, BiGT. The semiconductor device 1 comprises a semiconductor body 6 with a top side 30, like an emitter side, and a bottom side 20, like a collector side. The semiconductor body 6 is based, for example, on silicon. At the top side 30, there is a first electrode which is, for example, an emitter electrode 33.

Correspondingly, at the bottom side 20 there is a second electrode which is, for example, a collector electrode 23. Further, at the top side 30 there are two gate electrodes 41, 42 which are separated from the semiconductor body 6 by an electrical insulation layer 43 and from the emitter electrode 33 by a further electrical insulation layer 44, like gate oxide layers. The emitter electrode 33 may completely or mostly cover the top side 30 and the gate electrodes 41, 42, for example. The gate electrodes 41, 42 are, for example, structured layers of poly-Si. It is noted that in Figure 1 only a second region 32 with just the gate electrode 42 is shown.

Moreover, the semiconductor body 6 includes an emitter region 61 at the top side 30. The emitter region 61 is N-conductive, for example, and is embedded in a well region 62 which is P-conductive. To electrically fix the well region 62 at an electric potential of the emitter electrode 33, there are optionally P-conductive plug regions 65 to connect the emitter electrode 33 and the well region 62. A largest part of the semiconductor body 6 is made of a drift region 63 which is N-conductive. Optionally, on a side of the drift region 63 next to the bottom side 20 there can be a buffer region 64 being N-conductive as well, for example.

At the bottom side 20, the semiconductor body 6 has a centrally arranged pilot region 21 and a circumferential mixed region 22, see also Figure 2. In the pilot region 21, the semiconductor body 6 is uniformly N-conductive next to the collector electrode 23. In the mixed region 22, there are N-conductive first sub-regions 221 and P-conductive second sub-regions 222. The first and second sub-regions 221, 222 are arranged in an alternating manner. Optionally, there is an edge region 24 all around the mixed region 22. It is possible that the edge region 24 is P-conductive. It is noted that in Figure 1 only the mixed region 22 is shown.

In the mixed region 22, see Figure 2, there can be parallel stripes of the sub-regions 221, 222. In four quadrant fields defined by the cross-shaped pilot region 21, the stripes may run diagonally. In border regions between the quadrant fields and arranged in elongations of bars of the cross the pilot region 22 forms, the sub-regions 221, 222 may also be arranged as parallel stripes but oriented in parallel with the respectively assigned bar of the cross. Optionally, in the quadrant fields and in the border regions the sub-regions 221, 222 may be arranged with different periodicities.

Concerning details on the doping levels, shapes and dimensions of the respective regions, variation possibilities of the pattern of the mixed region 22 and the pilot region 21, reference is made to documents US 2010/0276727 Al and WO 2015/097157 A1, the disclosure content of which is hereby included by reference.

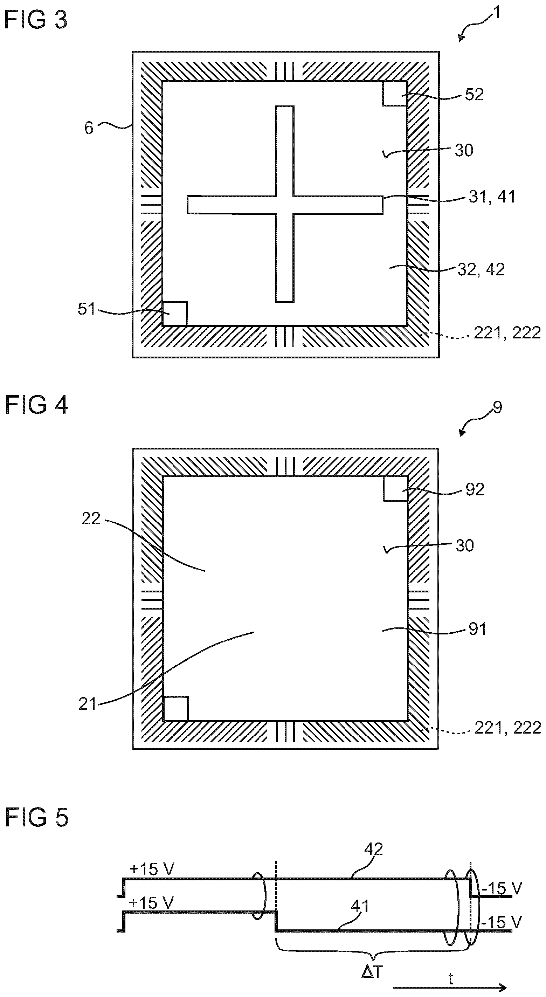

In Figure 3 it is shown that the gate electrode 41 is present in a first region 31 of the top side 30. Said first region 31 is congruent with the pilot region 21. Correspondingly, the gate electrode 42 is present in the second region 32 and is congruent with the mixed region 22. Hence, the first region 31 is atop the pilot region 21 and the second region 32 is atop the mixed region 22. With this design, and as the gate electrodes 41, 42 are separately electrically addressable, the pilot region 21 and the mixed region 22 can be turned on and off individually.

To electrically contact the gate electrodes 41, 42, optionally there is first contact pad 51 to address the gate electrode 41 in the first region 31 and a second contact pad 52 to address the gate electrode 42 in the second region 32. The contact pads 51, 52 may be placed in opposite corners of the top side 30 but, for example, still atop the second region 32 and, thus, possibly not atop the edge region 24. For example, the first contact pad 51 is connected to the gate electrode 41 in the first region 31 by an internal electric wiring, not shown. The contact pads 51, 52 may be metallic contact pads in electrical contact with the gate electrodes 41, 42, respectively, and may be configured for a soldering process and/or for a wire bonding process.

Contrary to the design as can be seen from Figure 3, in the modification 9 of Figure 4 there is just one gate electrode 91 extending all over the pilot region 21 and the mixed region 22. Said single gate electrode 91 may be electrically contacted by a single contact pad 92.

In Figure 5 the addressing the gate electrodes 41, 42 over time t is illustrated wherein just one cycle is shown schematically. For example, the semiconductor device 1 is turned on in the first and second regions 31, 32 simultaneously by providing the two gate electrodes 41, 42 at a same time with a first voltage which is, for example, +15 V. However, the first region 31 is turned off earlier by setting the respective gate electrode 41 to a second voltage, like -15 V. Then, after a time difference ΔT, the gate electrode 42 in the second region 32 is addressed by also applying the second voltage.

For example, the time difference ΔT is, for example, at least 5 µs or at least 10 µs. Alternatively or additionally, the time difference ΔT is at most 100 µs or is at most 50 µs. Other than shown, the first and second regions 31, 32 may also be turned on at different moments, however, a corresponding temporal offset may be smaller than the time difference ΔT.

Thus, the two separated contact pads 51, 52 are connected to, for example, poly-Si stripes the gate electrodes 41, 42 are made of and above the pilot and mixed regions 21, 22. In this way, channels above the two regions 21, 22 can be controlled independently. Both gate electrodes 41, 42 are turned on simultaneously but the gate electrode 41 for the pilot region 21 is turned off before gate electrode 42 for the mixed region 22. During this time difference ΔT, a conduction plasma above the pilot region 21 is recombined without generating losses. The actual turn-off event is occurring when the second region 32 above the mixed region 22 is switched off, however, only a reduced amount of plasma needs to be removed from the drift region 63, leading to lower switching losses and improved reverse bias safety operating area, RBSOA, capabilities.

It is worth to mention that during the time difference ΔT the conduction losses are higher since the conduction current is only sustained in the RC-region, that is, in the second region 32 and mixed region 22. However, this time interval ΔT is in the range of, for example, 10 µs to 50 µs and therefore it is negligible for the typical switching frequencies of these high voltage devices.

For example, the switching frequency is at least 0.1 kHz or is at least 0.2 kHz or is at least 0.3 kHz or is at least 0.5 kHz. Alternatively or additionally, said switching frequency is at most 100 kHz or is at most 5 kHz or is at most 2 kHz.

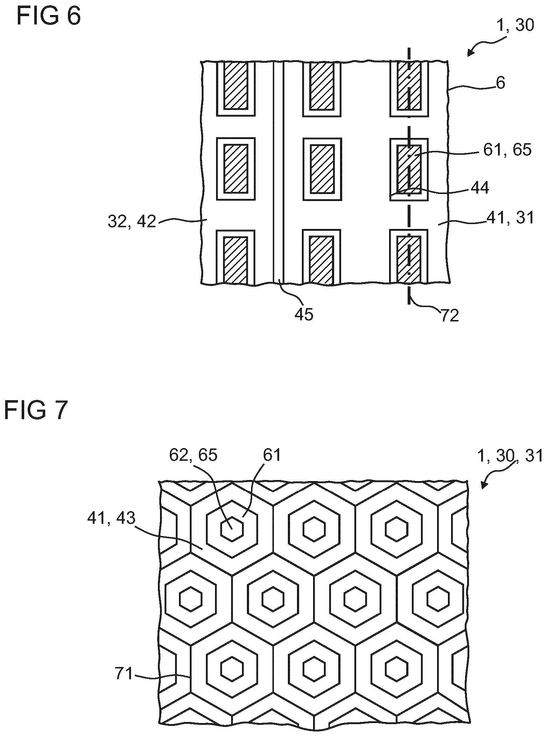

In Figures 6 and 7, different layouts of the gate electrodes 41, 42 are illustrated. According to Figure 6, the emitter regions 61 and the optional plug regions 65 are arranged along lines, also referred to as stripes 72. Along these stripes 72, the emitter electrode 33 makes electrical contact with the emitter regions 61 and the optional plug regions 65, and, thus, with the semiconductor body 6. In other areas, the emitter electrode 33 is not in conductive contact with the semiconductor body 6.

Optionally, the stripes 72 may run in a straight manner. It is possible that the stripes 72 have interruptions. In these interruptions, the respective gate electrode 41, 42 can be applied at the top side 30. Concerning the gate electrodes 41, 42, the first region 31 may electrically be separated from the second region 32 by means of an additional electrical insulation layer 45, like an oxide layer. Said additional electrical insulation layer 45 may at least in places run in parallel with the stripes.

Further optionally, an area proportion of the areas in which the emitter electrode 33 makes electric contact with the semiconductor body 6 on the overall top side 30 may be larger in the first region 31 than in the second region 32.

As the stripes 72 with the emitter regions 61 at the top side 30 may not strictly been aligned with the sub-regions 221, 222 at the bottom side 20, when seen in top view, there may be a minor offset or protrusion concerning the first region 31 and the pilot region 21; thus, said regions 21, 31 may not be exactly congruent. The same applies for the second region 32 in relation to the mixed region 22.

Otherwise, the same as to Figures 1 to 5 may also apply to Figure 6, and vice versa.

According to Figure 7, the top side 30 is of a cell-design and not of a stripe-design. That is, at the top side 30 there is a plurality of cells 71 which each comprising one of the emitter regions 61 and optionally one of the plug regions 65, if the latter are present. For example, the cells 71 are arranged in honey-comb manner, that is, are of hexagonal shape and are arranged in a regular hexagonal grid. The respective gate electrode 41 may form an outer edge of the cells 71.

In Figure 7, only a part of the first region 31 is illustrated. Analogously to Figure 6, there can be the additional electrical insulation layer 45 to electrically separate the gate electrodes 41, 42 and, thus, the regions 31, 32 from one another. As in Figure 6, the respective gate electrode 41, 42 may be each be a single simply-connected area so that a single one of the contact pads 51, 52 is sufficient to electrically contact the overall respective gate electrode 41, 42.

Otherwise, the same as to Figures 1 to 6 may also apply to Figure 7, and vice versa.

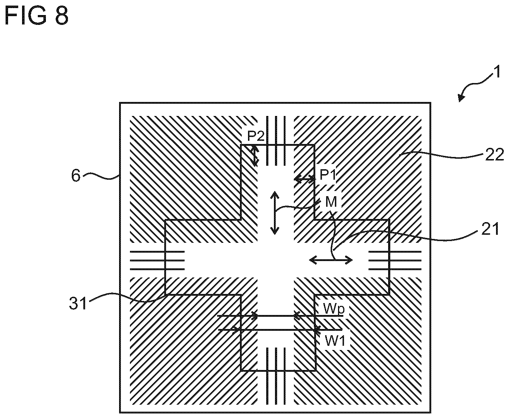

In Figure 8 it is shown that the first region 31 is not congruent with the pilot region 21 but exceeds beyond the pilot region 21, seen in top view. In other words, part of the mixed region 22 is covered by the first region 31. For example, the proportion of the mixed region 22 covered by the first region 31 may be at most 40% or at most 20% or at most 10% of an overall area content of the mixed region 22. Accordingly, there can be a protrusion P1, P2 of the first region 31 over the pilot region 21.

In the example of Figure 8, the pilot region 21 and the first region 31 have a same basic shape, that is, are of cross-shape in this example. That the regions 21, 31 have a same basic shape is also possible in all other examples of the BiGT.

For example, the pilot region 21 has at least one direction M of main extent. In the example of Figure 8, there are two directions M of main extent, namely the main directions of the bars forming the cross. Perpendicular to said at least one direction M, the pilot region 21 has a width Wp and the first region 31 has a width W1 wherein W1 is larger than Wp all along said at least one direction M. Perpendicular to said at least one direction M, the pilot region 21 and the first region 31 may be placed symmetrically, that is, that said at least one direction M may be an axis of mirror symmetry.

It is possible that the protrusion P1, P2 is the same all around the pilot region 21. However, otherwise it is possible that there are different protrusions P1, P2 perpendicular to directions M of main extent and in parallel with said directions M. By way of example, in Figure 8 the protrusion P2 may be larger than the protrusion P1.

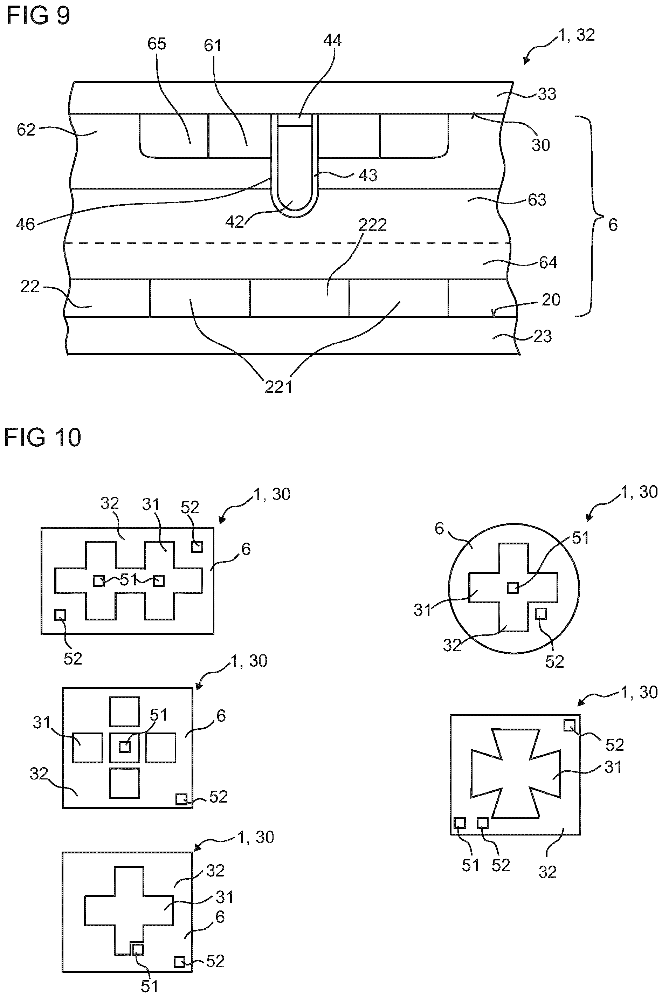

The semiconductor device 1 of Figure 9 is a BiGT of a trench design. Thus, the gate electrodes 41, 42 are placed in trenches 46 running from the top side 30 into the semiconductor body 6 and terminating within the drift region 63. The trenches 46 run through the well region 62 and consequently also through the emitter regions 61. The emitter regions 61 may directly adjoin the assigned trench 46.

The well region 62 may be a single region of constant depth into which the emitter regions 61 and optionally the plug regions 65 are formed by dopoing over, for example. It is possible that all of the top side 30 is covered by the emitter electrode 33 except for areas where the contact pads 51, 52 are applied, not shown. The gate electrodes 51, 52 in the trenches 46 may run until the edge region 24, not shown in Figure 9.

For defining the first and second regions 31, 32, either the affected trenches 46 are interrupted or the additional electrical insulation layer 45 is present, analogously to Figure 6, for example. If the trenches 46 for the first region 31 may not run until the edge region 24, then an additional wiring between the respective contact pad 51 and the first region 31 may be present, not shown.

Otherwise, the same as to Figures 1 to 8 may also apply to Figure 9, and vice versa.

In Figure 10, some examples of shapes of the first and second regions 31, 32 are illustrated. According to Figure 9, upper left, the first region 31 has the shape of a Jagiellonian cross. Optionally, there are two of the first contact pad 51 which may be placed at points of intersection of the bars of the Jagiellonian cross. Further optionally, there are two of the second contact pads 52 that may be placed in opposite corners of the top side 30. The top side 30 may be a rectangle.

In Figure 10, upper right, it is shown that the top side 30 is round, like a circular area. The contact pads 51, 52 may be arranged as centrally as possible. That is, the second contact pad 52 is next to the bars of the cross as which the first region 31 is shaped.

According to Figure 10, mid-left, overall the first region 31 is shaped as a cross, too, but has five sub-regions or also another number of sub-regions. The first contact pad 51 may be applied centrally while the second contact pad 52 is applied in a corner of the top side 30 which may be of square shape.

In Figure 10, mid-right, the first region 31 has the shape of a cross pattée so that the arms of the cross are of symmetric trapezoidal shape. Optionally, there are two of the second contact pads 52 with one of them adjacent to the first contact pad 51 in a corner of the top side 3. Either one of the second contact pads 52 may be omitted.

In Figure 10, lower left, it is illustrated that the two contact pads 51, 52 are arranged next to one another along an edge of the top side 30. Optionally, one of the bars of the cross that is shaped by the first region 31 has a cut out to better place the contact pads 51, 52.

Otherwise, the same as to Figures 1 to 9 may also apply to Figure 10, and vice versa.

The various designs of Figure 10 can apply both to the planar design of Figure 1 as well as to the trench design of Figure 9. The same applies for the stripe-design of Figure 6 and the cell-design of Figure 7 which can also both be applied to the planar design of Figure 1 as well as to the trench design of Figure 9.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: semiconductor device/BiGT
- 20: bottom side/collector side
- 21: pilot region
- 22: mixed region
- 221: first sub-region
- 222: second sub-region
- 23: collector electrode
- 24: edge region
- 30: top side/emitter side
- 31: first region
- 32: second region
- 33: emitter electrode
- 41: gate electrode in the first region
- 42: gate electrode in the second region
- 43: electrical insulation layer
- 44: further electrical insulation layer
- 45: additional electrical insulation layer
- 46: trench
- 51: first contact pad
- 52: second contact pad
- 6: semiconductor body
- 61: emitter region
- 62: well region
- 63: drift region
- 64: buffer region
- 65: plug region
- 71: cell
- 72: stripe
- 9: modification of a BiGT
- 91: single gate electrode
- 92: single gate contact pad
- M: direction of main extent
- P: protrusion
- ΔT: difference in turn-off times
- t: time
- V: voltage
- W1: width of the first region
- Wp: width of the pilot region

## Claims

1. A bi-mode insulated gate transistor (1), BiGT, comprising:
- a pilot region (21) and a mixed region (22) at a bottom side (20),
- a first region (31) at a top side (30) opposite the bottom side (20) and atop the pilot region (21), and a second region (32) at the top side (30) and atop the mixed region (22), wherein
- the first region (31) and the second region (32) are each provided with a gate electrode (41, 42),
- the gate electrodes (41) in the first region (31) and in the second region (32) are electrically addressable independent from one another.

2. The BiGT (1) according to the preceding claim,
wherein, seen in top view of the top side (30), the first region (31) is at least as broad as the pilot region (21).

3. The BiGT (1) according to any one of the preceding claims, wherein, seen in top view of the top side (30), the second region (32) completely surrounds the first region (31), and wherein, seen in top view of the top side (30), the first region (31) is congruent with the pilot region (21) and the second region (32) is congruent with the mixed region (22).

4. The BiGT (1) according to any one of the preceding claims, further comprising a first contact pad (51) and a second contact pad (52) both being located at the top side (30), wherein the gate electrode (41) in the first region (31) is in electrical contact with the first contact pad (51) and the gate electrode (42) in the second region (32) is in electrical contact with the second contact pad (52),
wherein the first contact pad (52) is distant from and electrically separated from the second contact pad (52).

5. The BiGT (1) according to the preceding claim,
wherein, seen in top view of the top side (30), at least one of the first contact pad (51) or the second contact pad (52) is placed at a corner of the top side (30).

6. The BiGT (1) according to any one of the preceding claims, further comprising a semiconductor body (6), a collector electrode (23) and an emitter electrode (33),
wherein the emitter electrode (33) is located at the top side (30) so that the top side (30) is an emitter side of the semiconductor body (6),
wherein the collector electrode (23) is located at the bottom side (20) so that the bottom side (20) is a collector side of the semiconductor body (6).

7. The BiGT (1) according to the preceding claim,
wherein the semiconductor body (6) comprises a plurality of emitter regions (61) of a first conductivity type and a plurality of well regions (62) of a second conductivity type different from the first conductivity type, each of the emitter regions (61) is embedded in one of the well regions (62), the emitter regions (61) being electrically contacted by the emitter electrode (33),
wherein the semiconductor body (6) further comprises a drift region (63) of the first conductivity type, the well regions (62) are embedded in the drift region (63),
wherein, seen in cross-section, the gate electrodes (41, 42) run from next to the emitter regions (61) along the associated well regions (62) to the drift region (63), wherein the gate electrodes (41, 42) are electrically insulated from the emitter electrode (33) and the semiconductor body (6) by means of at least one electrical insulation layer (43, 44).

8. The BiGT (1) according to claim 6 or 7,
wherein the pilot region (21) is uniformly of the second conductivity type and the mixed region (22) comprises first sub-regions (221) of the first conductivity type and second sub-regions (222) of the second conductivity type arranged in an alternating manner.

9. The BiGT (1) according to any one of claims 6 to 8,
wherein the pilot region (21) and the mixed region (22) directly adjoin the collector electrode (23) and run in parallel with the collector electrode (23),
wherein the semiconductor body (6) is of silicon.

10. The BiGT (1) according to any one of the preceding claims,
wherein, seen in top view of the bottom side (20), the pilot region (21) has the shape of a plus sign.

11. The BiGT (1) according to any one of the preceding claims,
wherein the gate electrodes (41, 42) are of a planar design so that the gate electrodes (41, 42) are located on top of the top side (30) and run in parallel with the top side (30).

12. The BiGT (1) according to any one of claims 1 to 10, wherein the gate electrodes (41, 42) are of a trench design so that the gate electrodes (41, 42) are arranged in trenches (46) extending from the top side (30) into the semiconductor body (6) towards the bottom side (20) but not until the bottom side (20).

13. A method for operating the BiGT (1) of any one of the preceding claims comprising:
- repeatedly turning on and turning off the BiGT (1) by applying different voltages to the gate electrodes (41, 42), wherein the gate electrodes (41, 42) are addressed independently of one another.

14. The method according to the preceding claim,
wherein, per each operation cycle of the BiGT (1), the gate electrode (41) in the first region (31) is turned off prior to the gate electrode (42) in the second region (32).

15. The method according to claim 13 or 14,
wherein, per each operation cycle of the BiGT (1), the gate electrode (41) in the first region (31) and the gate electrode (42) in the second region (32) are turned on simultaneously.
